Europäisches Patentamt

European Patent Office

Office européen des brevets

(11) Publication number: **0 388 733**
**A1**

## EUROPEAN PATENT APPLICATION

(21) Application number: **90104510.4**

(51) Int. Cl.5: **H01L 21/20**

(22) Date of filing: **09.03.90**

(30) Priority: **09.03.89 JP 56940/89**

(43) Date of publication of application:
**26.09.90 Bulletin 90/39**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Takasaki, Kanetake**
**27-10-703 Omorikita 1-chome**
**Ota-ku, Tokyo 143(JP)**

(74) Representative: **Schmidt-Evers, Jürgen,**
**Dipl.-Ing. et al**
**Patentanwälte Mitscherlich, Gunschmann**
**Dr. Körber, Schmidt-Evers, Melzer, Dr. Schulz**
**Steinsdorfstrasse 10**
**D-8000 München 22(DE)**

(54) **Method of fabricating semiconductor devices.**

(57) A method of fabricating semiconductor devices comprising the steps of selectively forming a mask layer (3) composed of silicon oxynitride (2) on a silicon substrate (1), and epitaxially growing a III-V compound semiconductor layer (5) upon the silicon substrate (1) in which the mask layer (3) is not formed (4).

# FIG. 1 C

## METHOD OF FABRICATING SEMICONDUCTOR DEVICES

### FIELD OF THE INVENTION

The present invention relates to a method of fabricating semiconductor devices, and is applicable to a method of fabricating semiconductor devices which is capable of growing a III-V compound semiconductor layer, such as gallium arsenide (GaAs), on a silicon (Si) substrate and which is capable of making devices, such as MESFETs (Fig. 6), LEDs (Fig. 7) and photo detectors (Fig. 8), on the compound semiconductor layer. More specifically, the invention relates to a method of fabricating semiconductor devices which is capable of substantially reducing crystal defects of the compound semiconductor layer and also warp of the Si substrate.

### DESCRIPTION OF THE PRIOR ART

In recent years, semiconductor devices composed of III-V compound semiconductors such as gallium arsenide (GaAs) are well known in their usefulness because they can be operated in higher speeds, as compared with semiconductor devices composed of silicon (Si), and because they also have a light-emitting function that is absent in the devices composed of Si. However, the semiconductor devices composed of GaAs are lagging far behind those composed of Si in practical use, because large-diameter substrates of GaAs are difficult to be made and insufficient in mechanical strength. Therefore, there has been proposed an attempt that a compound semiconductor layer is grown on the entire surface of a Si substrate which can be easily made into a large-diameter substrate and which is also superior in mechanical strength. Semiconductor devices are formed on the compound semiconductor layer. However, a large number of crystal defects resulting from the mismatching of lattice constants and the like arise in the compound semiconductor layer obtained by such a method. The crystal defects strongly influence the electrical, mechanical, and optical properties of the semiconductor. Moreover, there is another problem that the Si substrate is concavely warped downward because the compound semiconductor (for example, GaAs) differs in thermal expansion coefficient from Si (between GaAs and Si, the thermal expansion coefficient of GaAs is greater). Note that the warp of the Si substrate occurs since GaAs shrinks more than Si at the time that, after GaAs has been grown on the Si substrate at a growth temperature of, for example, 750°C, the temperature is lowered to room temperature (25°C).

In order to avoid the above described crystal defects of the compound semiconductor layer and warp of the Si substrate, there has been proposed a method of epitaxially growing a compound semiconductor layer upon a Si substrate with the aid of a mask layer composed of silicon nitride (SiN).

However, in the conventional method described above, since the internal stress (tensile stress) of the mask layer composed of SiN is very high, defects are induced in the Si substrate immediately under the mask layer composed of SiN, particularly around the edges of the mask layer composed of SiN. The internal stress abnormally increases the defects around the edges of the mask layer of the compound semiconductor layer that has been grown epitaxially upon the Si substrate. Consequently, the crystal growth of the compound semiconductor layer is remarkably degraded.

In addition, since the internal stress of the mask layer composed of SiN is very high, it acts so that the Si substrate is concavely warped downward. Therefore, even if the compound semiconductor layer is divided into a plurality of regions in order to reduce the warp of the Si substrate, the warp of the Si substrate cannot be substantially reduced.

Accordingly, it is an object of the present invention to provide an improved method of fabricating semiconductor devices which is capable of substantially reducing the crystal defects of the compound semiconductor layer as produced by the prior art and also the warp of the Si substrate as produced by the prior art.

### SUMMARY OF THE INVENTION

In accordance with an important aspect of the present invention, there is provided a method of fabricating semiconductor devices comprising the steps of selectively forming a mask layer composed of silicon oxynitride on a silicon substrate, and epitaxially a growing III-V compound semiconductor layer upon the silicon substrate in which the mask layer is not formed.

A composition ratio of oxygen atom ($n_2$) to nitrogen atom and oxygen atom ($n_1 + n_2$) in the silicon oxynitride may be $0.1 \leq n_2/(n_1 + n_2) \leq 0.5$.

The III-V compound semiconductor layer may be grown by a MOCVD (metalorganic chemical-vapor deposition) method. The III-V compound semiconductor layer may also be grown by a MBE (molecularbeam epitaxy) method.

In addition, the mask layer may have a thickness of between 500 Å and 2000 Å.

In addition, the compound semiconductor layer may have a layer thickness of between 2 μm and 5 μm.

The present invention is constructed such that the mask layer used in the epitaxial growth of the semiconductor device layers upon the silicon substrate is composed of silicon oxynitride.

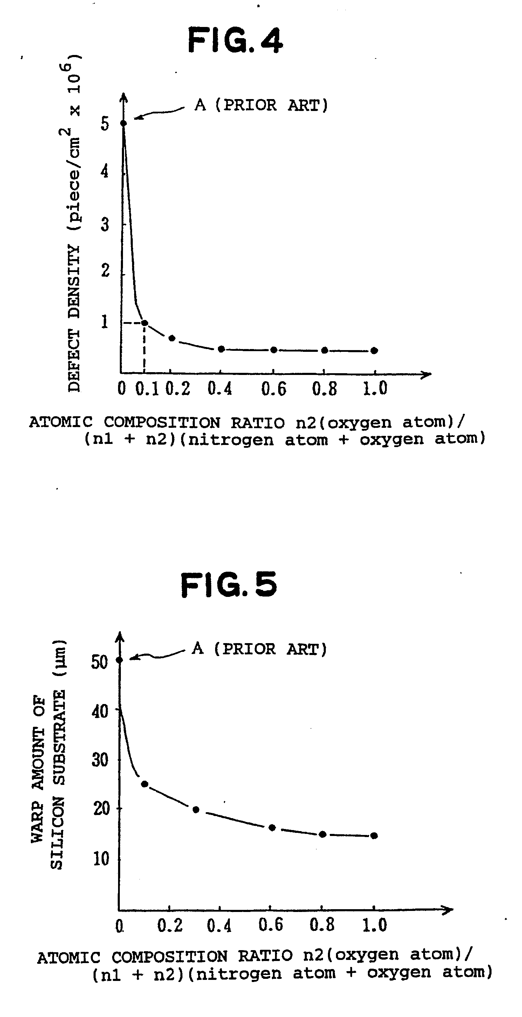

The defect density of the GaAs layers, warp amount of the Si substrate, and stress of the mask layer were measured by varying from 0 to 1 the composition ratio $n2/(n1 + n2)$ of oxygen atom ($n2$) to nitrogen atom and oxygen atom ($n1 + n2$) in the mask layer composed of silicon oxynitride ($SiO_{n2}N_{n1}$). The measurement results were obtained, as shown in Fig. 4, Fig. 5 and Fig. 2. The dimension and growth conditions of the substrate, mask layers and GaAs layers will be described in detail in an embodiment to be described hereinafter. The mask layers are composed of $Si_3N_4$ when the composition ratio is 0, and SiO when the composition ratio is 1.

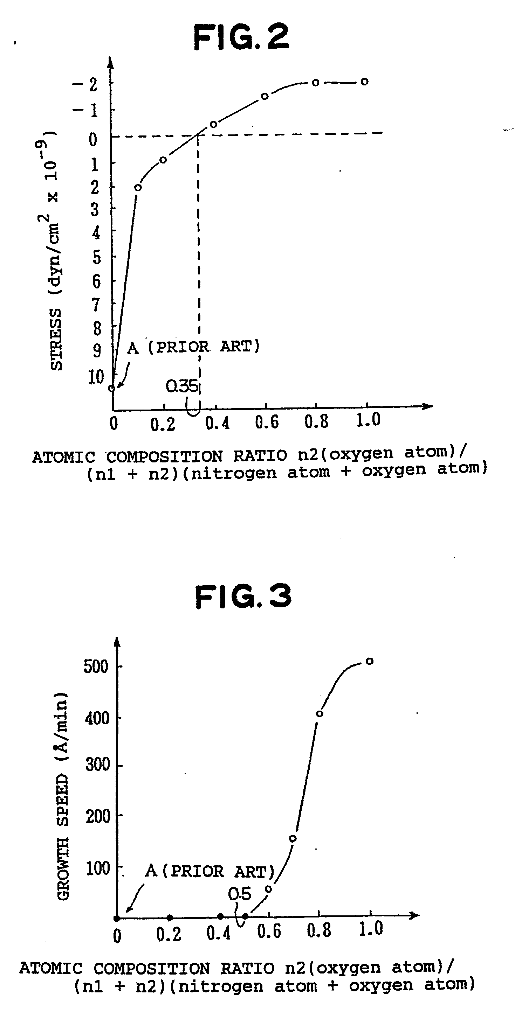

Therefore, if the mask layers are composed of silicon oxynitride in accordance with present invention, (1) as shown in Fig. 2, the stress (internal stress) of the mask layers can be made lower than that of the conventional silicon nitride (indicated by A), (2) as shown in Fig. 4, the crystal defects of the compound semiconductor layers can be substantially reduced than those of the conventional silicon nitride (indicated by A), and (3) as shown in Fig. 5, the warp of the silicon substrate can be substantially reduced than that of the conventional silicon nitride (indicated by A).

In addition, it is preferable that, in the present invention, the composition ratio $n2/(n1 + n2)$ be above 0.1 in order to substantially reduce the crystal defects, as will be understood from the results shown in Fig. 4. In addition, the composition ratio is preferably below 0.5 in order to prevent the compound semiconductor layers from being grown upon the mask layers, as will be understood from the relationship between the composition ratio and the growth speed on the mask layers.

BRIEF DESCRIPTION OF THE DRAWINGS

The above and other objects and advantages will become apparent from the following detailed description when read in conjunction with the accompanying drawings wherein:

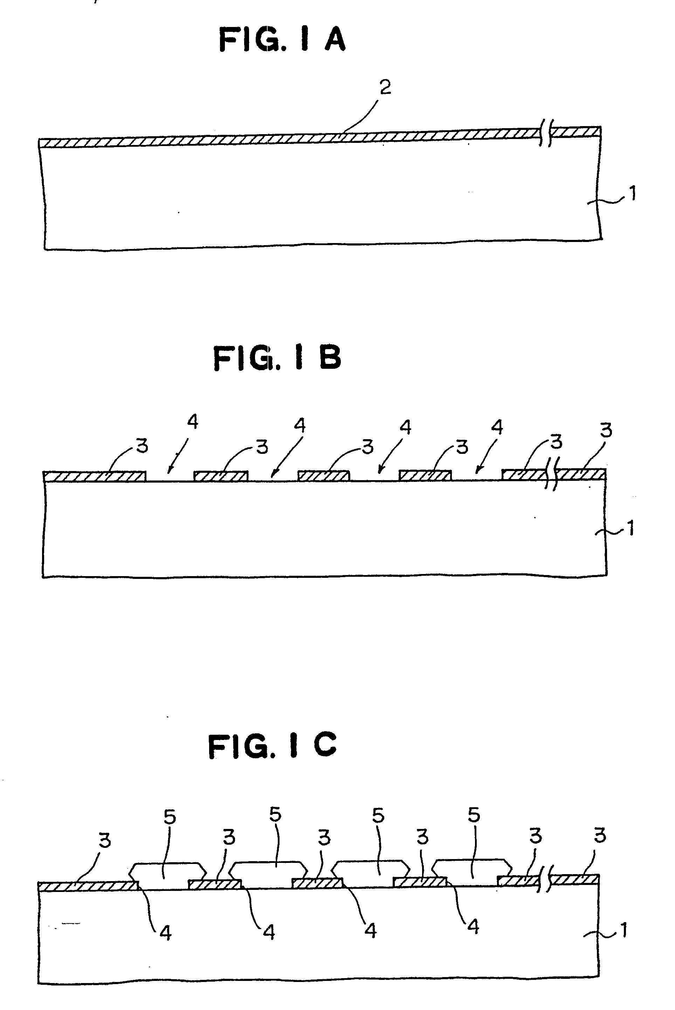

Figures 1A, 1B and 1C are diagrams used to explain an embodiment of fabrication processes of a method for fabricating semiconductor devices according to the present invention;

Figure 2 is a diagram showing the relationship between the atomic composition ratio and the stress of the mask layer (silicon oxynitride) of Figure 1C;

Figure 3 is a diagram showing the relationship between the atomic composition ratio and the growth speed of the compound semiconductor layer (GaAs) on the mask layer;

Figure 4 is a diagram showing the relationship between the atomic composition ratio and the defect density in the compound semiconductor layer (GaAs) that has grown epitaxially;

Figure 5 is a diagram showing the relationship between the atomic composition ratio and the warp amount of the wafer at the time that the compound semiconductor layer (GaAs) is grown on the Si substrate of 2 inches in diameter and about 500 μm thickness and then the temperature is lowered to room temperature;

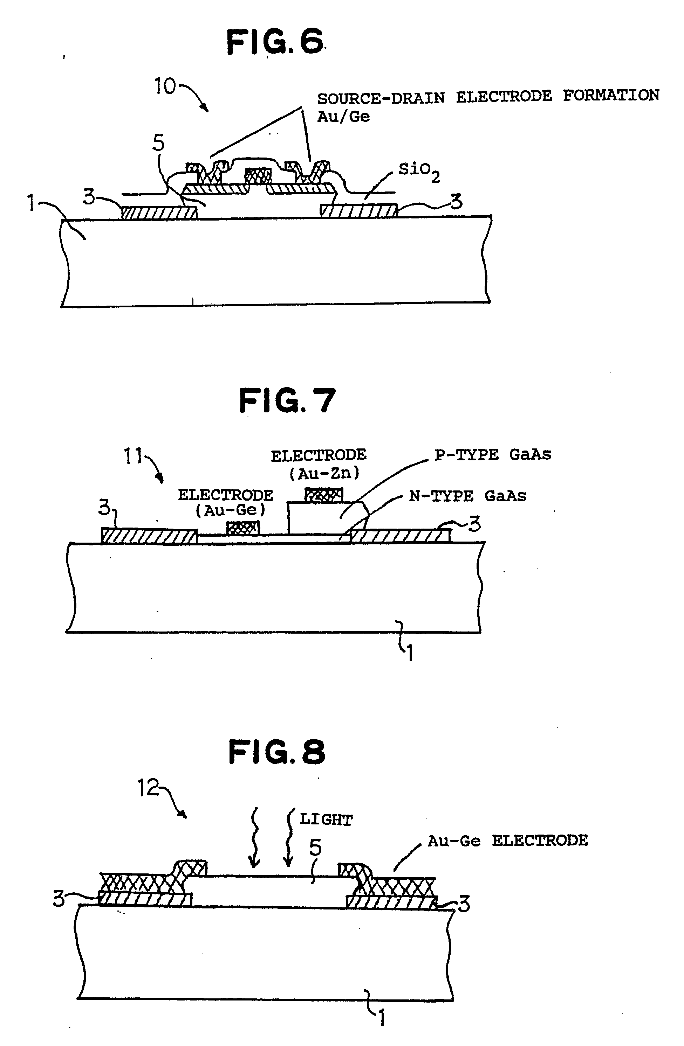

Figure 6 is a cross sectional view illustrating metal-semiconductor field-effect transistors (MESFETs) which are fabricated by using the compound semiconductor layers (GaAs) that have been epitaxially grown;

Figure 7 is a cross sectional view illustrating a light-emitting diode (LED) which is fabricated by using a p-type compound semiconductor layer (GaAs) and a n-type compound semiconductor layer (GaAs); and

Figure 8 is a cross sectional view illustrating a photo detector which is fabricated by using the compound semiconductor layer (GaAs).

DESCRIPTION OF THE PREFERRED EMBODIMENTS

Referring to Figs. 1 through 5, there is shown a preferred embodiment of a method of fabricating semiconductor devices in accordance with the present invention. Figs. 1A to 1C are used to explain the fabrication process of the embodiment. Fig. 2 is used to show the relationship between the atomic composition ratio and the stress of the mask layer (silicon oxynitride) of the embodiment. Fig. 3 is used to show the relationship between the atomic composition ratio and the growth speed of the compound semiconductor layer (GaAs) on the mask layer (silicon oxynitride) of the embodiment. Fig. 4 is used to show the relationship between the atomic composition ratio and the defect density in the compound semiconductor layer (GaAs) that has grown epitaxially. Fig. 5 is used to show the relationship between the atomic composition ratio and the warp amount of the wafer at the time that the compound semiconductor layer (GaAs) is grown on a Si substrate of 2 inches in diameter and about 500 $\mu$m thickness and then the temperature is lowered to room temperature (25°C).

In the figures, a Si substrate is designated by 1 and a silicon oxynitride layer by 2. 3 designates mask layers composed of the silicon oxynitride layer 2, which are formed by selectively etching the silicon oxynitride layer 2. 4 designates openings and 5 designates compound semiconductor layers composed of, for example, GaAs.

Note that the atomic composition ratio n2 (oxygen atom) / (n1 + n2) (nitrogen atom + oxygen atom) shown in Figs. 2 to 5 means a composition ratio of oxygen atom to nitrogen atom and oxygen atom in the silicon oxynitride of the mask layer 3. The point A shown in Figs. 2 to 5 represents a atomic composition ratio of the aforesaid conventional method (SiN containing no oxygen ($O_2$)). In addition, the stress value of plus sign shown in Fig. 2 represents that a tensile stress is acting, while the stress value of minus sign represents that a compressive stress is acting.

The fabrication process will hereinafter be described in detail.

As shown in Fig. 1A, by a CVD (chemical vapor deposition) method which uses, for example, a gas mixture of $SiH_4$ (gas), $NH_3$ (gas) and $N_2O$ (gas) at a temperature of 850°C, the silicon oxynitride layer 2 of, for example, 1000 Å layer thickness, is deposited on the Si substrate 1 of 2 inches in diameter and about 500 $\mu$m thickness. The deposition of the silicon oxynitride layer 2 may be performed by a sputter deposition method.

Next, as shown in Fig. 1B, by wet chemical etching using, for example, hydrofluoric acid (HF) solution, the silicon oxynitride layer 2 is selectively etched so that the mask layers 3 in the form of stripe will be formed. In this embodiment, the width of the mask layers 3 is 10 $\mu$m, the space between the mask layers 3 is 10 $\mu$m, and the layer thickness of the mask layers 3 is 1000 Å. In addition, the mask layers can also be made into other forms such as rectangular forms, circular forms and lattice forms. In addition, it is preferable that the mask layer thickness of silicon oxynitride be between 500 Å and 2000 Å. If below 500 Å, arsenic (As) during the epitaxial growth of GaAs layer will be permeated. If above 2000 Å, crystal defects and warp will be increased as internal stress becomes very higher. At the same time as the mask layers 3 are formed, openings 4 are also formed which remove the silicon oxynitride layer 2 from the surface of the Si substrate 1, as shown in Fig. 1B.

Thereafter, as shown in Fig. 1C, by a MOCVD (metalorganic chemical-vapor deposition) method which uses, for example, trimethylgallium (Ga-($CH_3$)$_3$(gas)) or triethylgallium for the gallium component (Ga) and arsine ($AsH_3$(gas)) for the arsenic component (As) at a temperature of 700°C and a pressure of 76 Torr (0.1 atm), GaAs is epitaxially grown upon the Si substrate 1 within the openings 4 with the aid of the mask layers 3 composed of silicon oxynitride. Consequently, the compound semiconductor layers 5 of 3 $\mu$m thickness which are composed of GaAs are formed on the Si substrate, as shown in Fig. 1C. The compound semiconductor layers 5 can also be formed by a MBE (molecular-beam epitaxy) method that is an epitaxial process involving the reaction of one or more thermal beams of atoms or molecules with a crystalline surface under ultrahigh vaccum conditions ($10^{-10}$ Torr). In addition, it is preferable that the layer thickness of the compound semiconductor layers 5 be between 2 $\mu$m and 5 $\mu$m. If below 2 $\mu$m, crystal defects will arise, and if above 5 $\mu$m, cracks will occur at the surfaces of the compound semiconductor layers 5. Note that, in order to epitaxially grow the compound semiconductor layers 5 composed of GaAs with the aid of the mask layers 3 composed of silicon oxynitride, the atomic composition ratio is preferably below 0.5, as clearly shown in Fig. 3.

That is to say, since in the above described embodiment the mask layers 3 used in the epitaxial growth of the compound semiconductor layers 5 upon the Si substrate 1 are composed of silicon oxynitride, the crystal defects in the compound semiconductor layers 5 can be substantially reduced and also the warp of the Si substrate 1 can be substantially reduced. It is considered that, as shown in Fig. 2, the substantial reduction in the crystal defects and warp can be achieved by making the stresses in the mask layers 3 lower than the point A corresponding to the conventional silicon nitride ($Si_3N_4$).

More specifically, the main reasons that the crystal defects of the compound semiconductor layers 5 can be substantially reduced are that, as shown in Fig. 4, the defect densities in the compound semiconductor layers 5 composed of GaAs are substantially reduced, as compared with the defect density of the conventional silicon nitride ($Si_3N_4$) indicated by the point A. Note that the defect density is preferably below 1 x $10^6$ pieces/$cm^2$ (the atomic composition ratio is preferably above 0.1) in order to make on the surfaces of the compound semiconductor layers 5 devices having better device performances such as Vth (threshold voltage), Gm (mutual inductance) and the like.

In addition, the reason that the warp of the Si substrate 1 can be substantially reduced is that, as shown in Fig. 5, the warp amount of the Si substrate 1 is substantially reduced, as compared with that of the conventional silicon nitride ($Si_3N_4$) indicated by the point A.

Moreover, as clearly shown in Fig. 2, the stresses in the mask layers 3 composed of silicon oxynitride have been more decreased than the stress of the conventional silicon nitride ($Si_3N_4$) indicated by the point A. From the figure, it is preferable that the atomic composition ratio be in the order of 0.35 (e.g., stress = 0).

Fig. 6 illustrates metal-semiconductor field-effect transistors (MESFETs) 10 which are fabricated by using the compound semiconductor layers (GaAs) 5 that have been epitaxially grown.

Fig. 7 illustrates a light-emitting diode (LED) 11 which is fabricated by using a p-type compound semiconductor layer (GaAs) and a n-type compound semiconductor layer (GaAs).

Fig. 8 illustrates a photo detector 12 which is fabricated by using the compound semiconductor layer (GaAs) 5 that has been epitaxially grown.

While the present invention has been described in relation to the Si substrate of 2 inches in diameter, it can also be applicable to a Si substrate of 4 inches or more in diameter.

While the above described embodiment has been described in relation to the selective epitaxial growth of the compound semiconductor layers 5 composed of GaAs, the present invention is also applicable to the selective epitaxial growth of the related III-V compound semiconductor such as $Al_xGa_{1-x}As$ or $In_xGa_{1-x}As$ (preferably, $0 < X \leq 0.35$).

While the subject invention has been described with relation to the preferred embodiment thereof, various modifications and adaptations thereof will now be apparent to those skilled in the art. All such modifications and adaptations as fall within the scope of the appended claims are intended to be covered thereby.

## Claims

1. A method of fabricating semiconductor devices comprising the steps of:
selectively forming a mask layer (3) composed of silicon oxynitride (2) on a silicon substrate (1); and
epitaxially growing a III-V compound semiconductor layer (5) upon said silicon substrate (1) in which said mask layer (3) is not formed.

2. A method as set forth in claim 1, wherein a composition ratio of oxygen atom ($N_2$) to nitrogen atom and oxygen atom ($n_1 + n_2$) in said silicon oxynitride (2) is $0.1 \leq n_2/(n_1 + n_2) \leq 0.5$.

3. A method as set forth in claim 1 or 2, wherein said III-V compound semiconductor layer (5) is grown by a MOCVD (metalorganic chemical-vapor deposition) method.

4. A method as set forth in claim 1 or 2, wherein said III-V compound semiconductor layer (5) is grown by a MBE (molecular beam epitaxy) method.

5. A method as set forth in anyone of claims 1 to 4, wherein said mask layer (3) has a thickness of between 500 Å and 2000 Å.

6. A method as set forth in anyone of claims 1 to 5, wherein said compound semiconductor layer (5) has a layer thickness of between 2 $\mu$m and 5 $\mu$m.

7. A method as set forth in anyone of claims 1 to 6, which is used for fabricating metal semiconductor field-effect transistors (10).

8. A method as set forth in anyone of claims 1 to 6, which is used for fabricating a light-emitting diode (11).

9. A method as set forth in anyone of claims 1 to 6, which is used for fabricating a photo detector (12).

# FIG. I A

# FIG. I B

# FIG. I C

EP 0 388 733 A1

# FIG.2

STRESS (dyn/cm$^2$ × 10$^{-9}$)

A (PRIOR ART)

0.35

ATOMIC COMPOSITION RATIO n2(oxygen atom)/
(n1 + n2)(nitrogen atom + oxygen atom)

# FIG.3

GROWTH SPEED (Å/min)

A (PRIOR ART)

0.5

ATOMIC COMPOSITION RATIO n2(oxygen atom)/
(n1 + n2)(nitrogen atom + oxygen atom)

# FIG.4

A (PRIOR ART)

DEFECT DENSITY (piece/cm$^2$ x 10$^6$)

5
4
3
2
1

0 0.1 0.2  0.4  0.6  0.8  1.0

ATOMIC COMPOSITION RATIO n2(oxygen atom)/
(n1 + n2)(nitrogen atom + oxygen atom)

# FIG.5

A (PRIOR ART)

WARP AMOUNT OF SILICON SUBSTRATE (μm)

50
40
30
20
10

0  0.2  0.4  0.6  0.8  1.0

ATOMIC COMPOSITION RATIO n2(oxygen atom)/
(n1 + n2)(nitrogen atom + oxygen atom)

# FIG. 6

10

SOURCE-DRAIN ELECTRODE FORMATION
Au/Ge

5

$SiO_2$

1

3

3

# FIG. 7

11

ELECTRODE
(Au-Zn)

P-TYPE GaAs

ELECTRODE
(Au-Ge)

N-TYPE GaAs

3

3

1

# FIG. 8

12

LIGHT

5

Au-Ge ELECTRODE

3

3

1

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| A | APPLIED PHYSICS LETTERS, vol. 54, no. 10, 6th March 1989, pages 910-912, American Institute of Physics, New York, US; T.F. KUECH et al.: "Selective epitaxy in the conventional metalorganic vapor phase epitaxy of GaAs" --- | | H 01 L 21/20 |
| A | APPLIED PHYSICS LETTERS, vol. 52, no. 3, 18th January 1988, pages 215-217, American Institute of Physics, New York, US; H.P. LEE et al.: "Photoluminescence studies of selective-area molecular beam epitaxy of GaAs film on Si substrate" ------ | | |
| | | | **TECHNICAL FIELDS SEARCHED (Int. Cl. 5)** |
| | | | H 01 L |

The present search report has been drawn up for all claims

| Place of search | Date of completion of the search | Examiner |
|---|---|---|
| THE HAGUE | 17-07-1990 | GELEBART Y.C.M. |